# EUROPÄISCHE PATENTANMELDUNG

(11) **EP 0 829 868 A1**
(43) Veröffentlichungstag der Anmeldung: **18.03.1998**
(21) Anmeldenummer: 96250249.8
(22) Anmeldetag: 31.10.1996
(51) Int. Cl.: G11B 7/26, G11B 23/38

(54) **Verfahren zur Herstellung von Glasmastern mit grafischen Darstellungen**

(30) Priorität: 11.09.1996 DE 19638747
(71) Anmelder: CDA Compact Disc Albrechts GmbH, 98529 Albrechts (DE)
(72) Erfinder: Luthardt, Uwe, 98597 Fambach (DE)
(74) Vertreter: Lüke, Dierck-Wilm, Dipl.-Ing.

(57) **Zusammenfassung**

Die Erfindung bezieht sich auf ein Verfahren zur Herstellung von Glasmastern mit grafischen Darstellungen auf den Glasmastern durch Beschichtung des Glasmasters mit Fotoresist und Übertragung der Daten auf den Glasmaster im Laser Beam Recorder (LBR), durch das Entwickeln der fotoempfindlichen Schicht und durch Metallisieren des Glasmasters.

Die Aufgabe der Erfindung, ein gattungsgemäßes Verfahren zu entwickeln, mit dem eine weitgehend gegen Nachahmung gesicherte Aufbringung von Kennzeichnungen/Dekorationen auch auf dem Informationsbereich des Glasmasters weitgehend ohne Eingriffe in den technologischen Prozeß der Informationseinbringung gewährleistet ist, wird dadurch gelöst, daß nach der Beschichtung des Glasmasters mit Fotoresist und nach dem Übertragen der Daten auf den Glasmaster im Laser Beam Recorder eine zusätzliche Belichtung des Glasmasters zur Abbildung einer fotografischen Vorlage erfolgt, wonach das Entwickeln und Metallisieren des Glasmasters vorgenommen werden.

## Beschreibung

Die Erfindung bezieht sich auf ein Verfahren zur Herstellung von Glasmastern mit grafischen Darstellungen gemäß dem Oberbegriff des Anspruches 1.

Die wirtschaftliche Bedeutung von CD's und CD-ROM's wecken bei den Herstellern den Wunsch nach einer sicheren und schwer nachahmbaren Kennzeichnung ihrer Produkte, um Originale und Piraterieprodukte voneinander unterscheiden zu können. Es besteht des weiteren der Wunsch, Speicher dieser Art dekorativ zu gestalten, um sie attraktiver und unverwechselbarer zu machen.

In der DE 43 44 125 A1 wird ein Verfahren zur Beschichtung metallisierter Oberflächen mit einem strahlenhärtbaren Beschichtungsmittel beschrieben, welches insbesondere auch für die Beschichtung der metallisierten Seite von CD's geeignet ist.

Auf die Beschichtung können mit konventionellen Druckfarben beliebige Kennzeichnungen aufgedruckt werden, die jedoch keine Fälschungssicherheit gewährleisten. Die Aufbringung des Beschichtungsmittels und das Bedrucken mit der Kennzeichnung erfolgen auf jede CD gesondert. Das Verfahren ist aufwendig.

In der DE 43 11 683 A1 wird ein Verfahren zur Herstellung eines Glasmasters für einen plattenförmigen optischen Speicher durch spurenweises Belichten der Fotolackschicht des Glasmasters mit einem Laserstrahl im Bereich der zu erzeugenden pits und nachfolgendes Entwickeln des Glasmasters bis die Fotolackschicht an den belichteten Stellen Vertiefungen aufweist angegeben.

Zur Herstellung von dauerhaften Kennzeichnungen auf diesen Compakt Disc, die mit optischen Mitteln erkennbar sind, und die eine Nachahmung des Produktes verhindern sollen, wird vorgeschlagen, eine ausgewählte Anzahl der Gesamtheit der lands als im Vergleich zu der Tiefe der pits flache Vertiefungen in der optischen Bezugsfläche auszubilden. Das entstehende Muster soll sich von der übrigen Oberfläche des Speichers je nach Lichteinfalls- und Betrachtungswinkel durch eine abweichende Graustufe abheben.

Mittels Hard- und Softwareeingriffen müssen Überlagerungen und damit Informationsänderungen vermieden werden. Es sind erhebliche Eingriffe in den Laserbeam-Recorder notwendig.

Es ist Aufgabe der vorliegenden Erfindung, diese Nachteile des Standes der Technik zu beseitigen und ein Verfahren zur Herstellung von Glasmastern mit grafischen Darstellungen zu entwickeln, mit dem eine weitgehend gegen Nachahmung gesicherte Aufbringung von Kennzeichnungen/Dekorationen auch auf dem Informationsbereich des Glasmasters weitgehend ohne Eingriffe in den technologischen Prozeß der Informationseinbringung gewährleistet ist.

Die Lösung dieser Aufgabe ergibt sich aus den Merkmalen des Anspruches 1. Die zusätzliche Belichtung des Glasmasters zur Abbildung einer Vorlage (Layout) ohne Verwendung eines Laser Beam Recorders, eingefügt in den bekannten Herstellungsprozeß des Glasmasters, schafft eine billige und zuverlässige Möglichkeit zur Aufbringung von fälschungsgesicherten Kennzeichnungen/Dekorationen auf CD/CD-ROM ohne Beeinträchtigung der Informationsübertragung.

Es werden gut sichtbare Grafiken erzielt, die auch im Informationsbereich einer CD aufgebracht sein können, ohne die elektrischen Meßwerte und damit die Abspielbarkeit der CD zu verändern oder gar zu gefährden.

Es wird eine gewisse Exklusivität mit einfachen Mitteln und geringen Kosten erzielt und ein Schutz gegen Nachahmer erreicht.

Je nach verwendeter Lichtstärke und Belichtungszeit werden verschiedene Abbildungseffekte erzielt. Es können sehr schwache grafische Abbildungen der Vorlage erreicht werden, die man nur unter einem bestimmten Winkel und unter bestimmten Lichtverhältnissen erkennt, oder es werden bei Anwendung hoher Lichtdosen spiegelnde Strukturen erzielt.

Weitere vorteilhafte Ausgestaltungen der Erfindung ergeben sich aus den Unteransprüchen.

Die Erfindung ist nachfolgend anhand eines Ausführungsbeispieles näher erläutert.

Voraussetzung für die Anwendung des Verfahrens ist eine Mastering-Technologie auf der Grundlage des Fotoresist-Verfahrens.

Die Herstellung des Glasmasters, von dem Matrizen gezogen werden können, die ihrerseits zur Massenherstellung von CD/CD-ROM dienen, erfolgt nach den bekannten Schritten.

Ausgangsobjekt ist eine Glasplatte, die mit einem Fotolack beschichtet ist (Resist-Master), und die im Laser Beam Recorder belichtet wird. Nach dem Master-Recording wird die vorgesehene fotografische Maske, die aus einer Grafikvorlage (Layout) erstellt wurde, positioniert. Es erfolgt die Projektion der fotografischen Maske auf den Glasmaster. Danach wird der Glasmaster entwickelt und anschließend metallisiert.

Der Glasmaster enthält nun bereits das gewünschte Kennzeichen, welches bei der Massenherstellung automatisch mitreproduziert wird und gegen Fälschungen weitgehend geschützt ist. Die Kennzeichnung oder Dekoration befindet sich nicht innerhalb oder auf einer zusätzlich aufgebrachten Schicht ohne sonstige Funktion.

Die Kennzeichnung oder die Dekoration befindet sich direkt in der Informationsebene, ohne die eingelesenen Informationen zu beeinträchtigen. Das Einbringen der Dekoration erfolgt vollkommen unabhängig vom Vorgang des Einbringens der Information in den Glasmaster.

Durch die Kenntnis der Lichtempfindlichkeit der Fotoschicht und der Belichtungsparameter ist ein definiertes Ablichten der Vorlage gewährleistet und damit eine Beeinflussung und Gestaltung der Dekoration möglich.

## Patentansprüche

1. Verfahren zur Herstellung von Glasmastern mit grafischen Darstellungen auf den Glasmastern durch Beschichtung des Glasmasters mit Fotoresist und Übertragung der Daten auf den Glasmaster im Laser Beam Recorder (LBR), durch das Entwickeln der fotoempfindlichen Schicht und durch Metallisieren des Glasmasters,
**dadurch gekennzeichnet,**
daß nach der Beschichtung des Glasmasters mit Fotoresist und nach dem Übertragen der Daten auf den Glasmaster im Laser Beam Recorder eine zusätzliche Belichtung des Glasmasters zur Abbildung einer fotografischen Vorlage erfolgt, wonach das Entwickeln und Metallisieren des Glasmasters vorgenommen werden.

2. Verfahren nach Anspruch 1, dadurch gekennzeichnet, daß die sichtbare Abbildung der fotografischen Maske in der Informationsebene des Glasmasters vorgenommen wird.

3. Verfahren nach Anspruch 1 und 2, dadurch gekennzeichnet, daß die Lichtstärke und die Belichtungszeit während der zusätzlichen Belichtung des Glasmasters entsprechend der Vorlage und dem zu erzielenden optischen Effekt variiert werden.
